# DEMANDE DE BREVET EUROPEEN

(11) **EP 1 494 270 A1**
(43) Date de publication de la demande: **05.01.2005**
(21) Numéro de dépôt: 04291490.3
(22) Date de dépôt: 14.06.2004
(51) Int. Cl.: H01L 21/285

(54) **Procédé de protection d'un élément d'un circuit intégré contre la formation d'un siliciure de métal.**

(30) Priorité: 25.06.2003 FR 0307690
(71) Demandeur: STMicroelectronics S.A., 92120 Montrouge (FR)
(72) Inventeur: Froment, Benoit, 38100 Grenoble (FR); Wacquant, Francois, 38330 St Ismier (FR)
(74) Mandataire: Casalonga, Axel

(57) **Abrégé**

L'invention porte sur un procédé de protection d'un matériau semiconducteur contre la formation d'un siliciure de métal, comprenant la formation sur le matériau d'une couche d'un alliage de silicium et de germanium. Dans ce procédé de protection, le matériau appartient à un composant d'un circuit intégré comportant d'autres composants devant faire l'objet d'une siliciuration. Ce procédé comporte les étapes suivantes :
a) un dépôt de la couche de l'alliage de silicium et de germanium (10) sur l'ensemble du circuit intégré,
b) un retrait de la couche de l'alliage de silicium et de germanium (10) des zones à siliciurer,
c) un dépôt d'un métal (11) sur la structure obtenue à l'étape b),
d) la formation d'un siliciure de métal (110) sur lesdites zones,
e) un retrait du métal n'ayant pas réagi et de l'alliage ternaire métal-silicium-germanium éventuellement formé,
f) un retrait de la couche de l'alliage de silicium et de germanium (10) afin de découvrir le composant non siliciuré.

## Description

L'invention concerne les circuits intégrés, et plus particulièrement la protection d'un composant de ce circuit contre la formation d'un siliciure de métal.

Actuellement, il existe un besoin dans le domaine de la microélectronique d'obtenir des composants présentant des résistances de valeurs différentes. Lorsque les composants d'un circuit intégré subissent une siliciuration, c'est-à-dire la formation d'un siliciure de métal sur des zones en silicium, l'alliage silicium/métal obtenu conduit à une résistance très faible de ces zones. Par contre, lorsque ce composant n'a pas été siliciuré, cette résistance est forte. Un exemple de composant devant habituellement présenter des résistances élevées est un transistor d'entrée/sortie d'un circuit. Pour obtenir des composants présentant des résistances élevées, il est donc envisagé de protéger ces composants de la siliciuration.

Actuellement, un procédé permettant la protection de certains éléments d'un circuit intégré contre la formation de siliciure de métal est connu.

Plus précisément, le procédé mettant en oeuvre le dépôt d'un bi-couche comportant une couche de tétraorthosilicate d'éthyle, plus connue sous le nom de TEOS surmontée d'une couche de nitrure de silicium est classiquement utilisé. Les zones du circuit intégré sur lesquelles la formation de siliciure de métal est souhaitée sont découvertes par un retrait local du bi-couche. Ce retrait comporte après gravure du nitrure de silicium un traitement chimique afin d'ôter le TEOS des zones à siliciurer. Ce traitement chimique comporte de l'acide fluorhydrique.

Cependant, ce procédé présente des inconvénients. Un premier inconvénient réside dans le budget thermique élevé utilisé dans le dépôt du bi-couche, et qui s'avère difficilement compatible avec une technologie CMOS.

Un autre inconvénient réside dans le fait que le traitement chimique à l'acide fluorhydrique attaque partiellement le matériau isolant situé dans les tranchées peu profondes (STI : Shallow Trench Isolation) séparant les différents composants du circuit intégré et cela peut générer des fuites de jonction lors de la siliciuration des transistors non protégés par le bi-couche.

L'invention propose un nouveau procédé ne présentant pas ces désavantages.

L'invention concerne un procédé de protection d'un matériau semi-conducteur contre la formation d'un siliciure de métal comprenant la formation sur le matériau d'un alliage de silicium et de germanium, dont sa teneur en germanium est, par exemple, comprise entre 5 et 50%, de préférence de l'ordre de 30%.

En d'autres termes, on remplace le bi-couche classiquement utilisé par une couche de silicium-germanium.

L'épaisseur de la couche de l'alliage de silicium et de germanium est de préférence supérieure à 50 Å, par exempl e de l'ordre de 200 Å.

L'invention s'applique avantageusement à un matériau appartenant à un composant d'un circuit intégré comportant d'autres composants devant faire l'objet d'une siliciuration, ce procédé comportant les étapes suivantes :
a) un dépôt de la couche de l'alliage de silicium et de germanium sur l'ensemble du circuit intégré,
b) un retrait de la couche de l'alliage de silicium et de germanium des zones à siliciurer,
c) un dépôt d'un métal sur la structure obtenue à l'étape b),
d)la formation d'un siliciure de métal sur lesdites zones,
e)un retrait du métal n'ayant pas réagi ; il est possible qu'un alliage de métal-silicium-germanium se forme sur une couche très fine, sur l'alliage de silicium et de germanium ; ce nouvel alliage peut être enlevé à cette étape du procédé ;
f)un retrait de la couche de l'alliage de silicium et de germanium afin de découvrir le composant non siliciuré.

Selon une variante de l'invention, le matériau à protéger appartient à une ligne de polysilicium.

Selon une variante de l'invention, le matériau à protéger appartient à l'une au moins des régions de source, de drain et de grille d'un transistor.

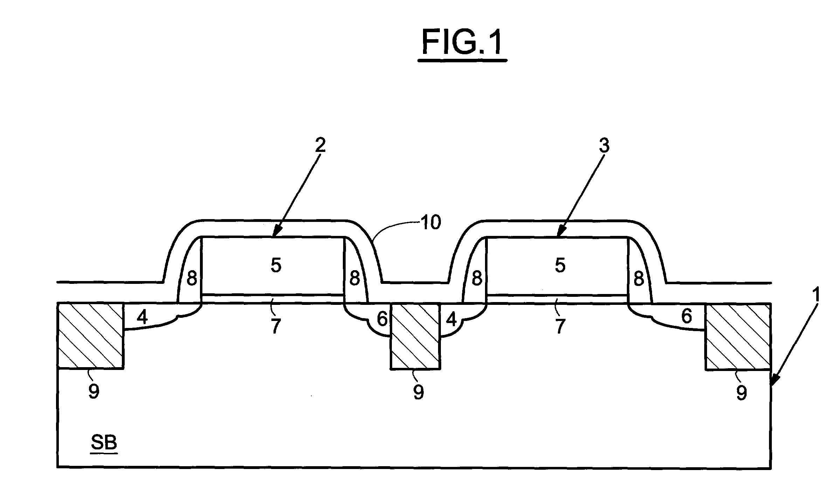

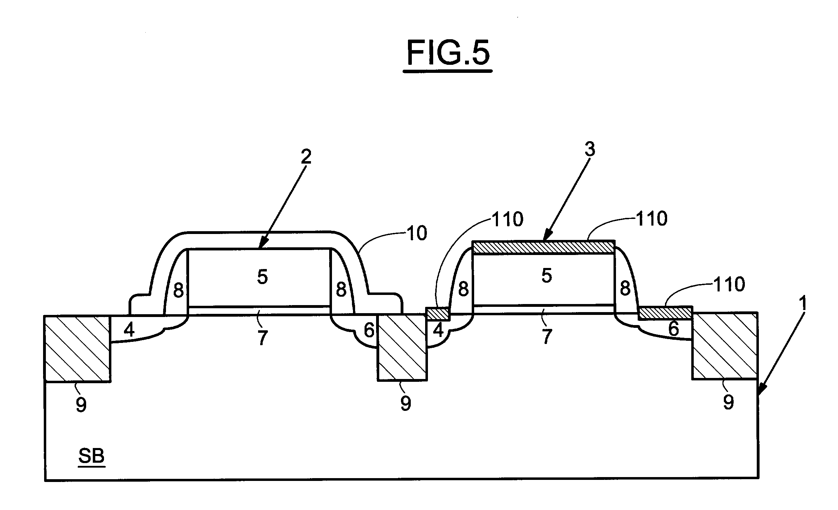

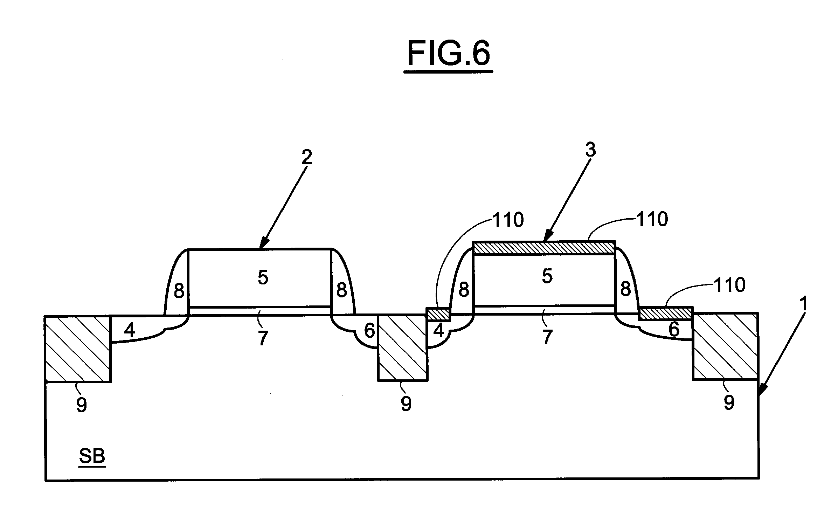

D'autres avantages et caractéristiques de l'invention apparaîtront à l'examen de la description détaillée d'un mode de mise en oeuvre, nullement limitatif, et des dessins annexés sur lesquels les figures 1 à 6 illustrent d'une façon très schématique, un mode de mise en oeuvre du procédé selon l'invention.

La figure 1 représente une plaque de silicium 1 d'un circuit intégré comportant à des fins de simplification deux transistors 2 et 3. Classiquement, les transistors 2 et 3 sont constitués d'une région de source 4, d'une région de grille 5, d'une région de drain 6, d'un oxyde de grille 7 et d'espaceurs isolants 8.

Les transistors sont séparés par des tranchées isolantes 9 du type STI.

Une couche d'un alliage silicium/germanium 10 a été déposée de façon amorphe sur l'ensemble du circuit intégré. Ce type de dépôt est classique et connu par l'homme du métier. Il est réalisé par dépôt chimique en phase vapeur (CDV) à l'aide d'une source de silicium telle que le silane, d'une source de germanium telle que le germane et d'un gaz porteur à une température de 700°C par exemple, et sous une pression de quelques centaines de torr, qui peut être beaucoup plus basse selon les équipements. La couche de silicium/germanium 10 a une épaisseur minimale de 50Å et est de préférence, de l'ordre de 200Å.

On suppose maintenant que seul le transistor 3 doit subir un traitement de siliciuration.

On procède alors à un retrait sélectif localisé de la couche de silicium-germanium 10. Un tel retrait est connu en soi et consiste à protéger par un masque les zones de la couche 10, qui ne doivent pas être retirées, puis à retirer les zones non protégées en utilisant par exemple un plasma fluoré.

L'utilisation de plasma fluoré est beaucoup moins agressive pour les matériaux du circuit intégré que l'utilisation de l'acide fluorhydrique.

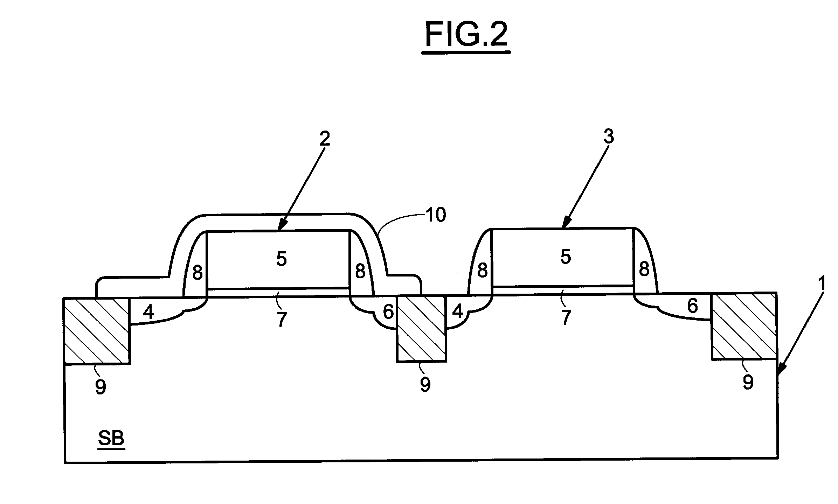

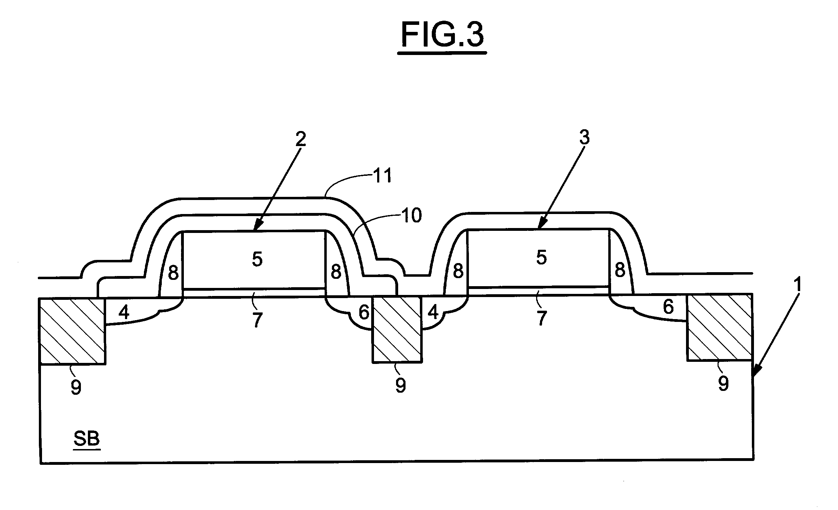

On obtient alors la structure illustrée sur la figure 2. On dépose ensuite (figure 3) une couche 11 de métal à siliciurer, comme le cobalt ou le nickel. Le cobalt sera utilisé pour exemplifier l'invention.

On procède ensuite de façon classique et connue en soi à une siliciuration.

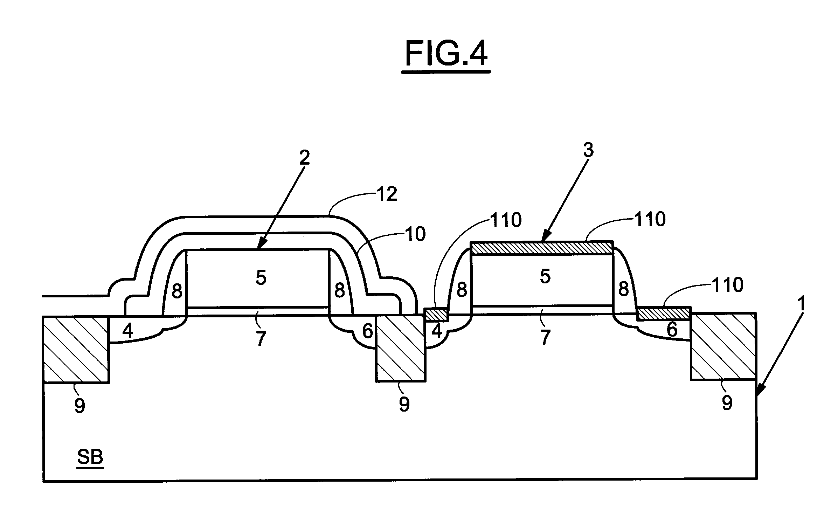

A l'issue de cette étape de siliciuration, on obtient la structure illustrée sur la figure 4. Sur cette figure, les zones 110 sont des alliages de silicium/cobalt obtenus suite à la siliciuration. Par ailleurs, lors de la siliciuration, une partie du cobalt va former avec la couche de l'alliage de silicium/germanium 10 une couche d'un mélange ternaire SiCoGe. La référence 12 désigne le cobalt n'ayant pas réagi lors de la siliciuration ainsi que l'alliage ternaire sous-jacent.

Le circuit va ensuite subir un traitement chimique afin de retirer de sa surface le cobalt n'ayant pas réagi lors de la siliciuration et le mélange ternaire SiCoGe. Les méthodes chimiques exposées ci-dessous sont connues et sont classiquement utilisées pour le retrait du cobalt. Ces procédés laissent inerte la couche de l'alliage de silicium/germanium.

Un traitement chimique classique met en oeuvre une solution appelée "SC1" (Standard Clean 1) constituée d'un mélange d'ammoniaque, de peroxyde d'hydrogène et d'eau dans un rapport pouvant être 1/1/10, ainsi qu'une solution appelée "SC2" (Standard Clean 2) constituée d'un mélange d'acide chlorhydrique, de peroxyde d'hydrogène et d'eau dans un mélange pouvant être 1/1/10.

Classiquement, la solution SC1 est utilisée à 65°C et la solution SC2 est utilisée à température ambiante. Ces solutions sont utilisées l'une après l'autre et dans n'importe quel ordre.

Une autre méthode pour retirer le cobalt peut être envisagée. Elle consiste, comme précédemment, en un traitement chimique utilisant deux solutions.

La première est la solution SC1 définie ci-dessus, la seconde appelée "SPM" (Sulfuric Peroxyde Mixture) se constitue d'un mélange d'acide sulfurique, de peroxyde d'hydrogène et d'eau en une proportion 8/5/1. La solution SPM est classiquement utilisée à une température comprise entre 80 et 160°C.

Ces deux traitements chimiques permettent de retirer le cobalt ou le nickel, dans le cas d'une siliciuration avec le nickel, mais aussi leur composé ternaire respectif SiCoGe ou SiNiGe. Ces mélanges ternaires sont attaqués très facilement par ce type de traitement chimique. La facilité de retrait du mélange ternaire est un avantage que présente ce procédé par rapport aux procédés de l'art antérieur.

La figure 5 représente le circuit intégré une fois ce traitement chimique effectué.

La figure 6 représente le circuit intégré une fois la couche 10 de silicium/germanium retirée. Cette couche d'alliage de silicium/germanium est retirée par exemple de la même façon que celle utilisée en référence à la figure 2. Contrairement au procédé de l'art antérieur, la couche de protection peut être retirée en fin de procédé par une méthode peu corrosive.

## Revendications

1. Procédé de protection d'un matériau semi-conducteur contre la formation d'un siliciure de métal, comprenant la formation sur le matériau d'une couche d'un alliage de silicium et de germanium (10).

2. Procédé de protection selon la revendication 1, **caractérisé par le fait que** l'épaisseur de la couche d'alliage de silicium et de germanium (10) est supérieure à 50 Å.

3. Procédé de protection selon la revendication 2, **caractérisé par le fait que** l'épaisseur de la couche de alliage de silicium et de germanium (10) est de l'ordre de 200 Å.

4. Procédé de protection selon la revendication 3, **caractérisé par le fait que** l'alliage de silicium et de germanium (10) a une teneur en germanium entre 5 et 50%.

5. Procédé de protection selon la revendication 4, **caractérisé par le fait que** l'alliage de silicium et de germanium (10) a une teneur en germanium de l'ordre de 30%.

6. Procédé de protection selon l'une quelconque des revendications 1 à 5, **caractérisé par le fait que** le matériau appartient à un composant d'un circuit intégré comportant d'autres composants devant faire l'objet d'une siliciuration, ce procédé comportant les étapes suivantes :
a) un dépôt de la couche de l'alliage de silicium et de germanium (10) sur l'ensemble du circuit intégré,
b) un retrait de la couche de l'alliage de silicium et de germanium (10) des zones à siliciurer,
c) un dépôt d'un métal (11) sur la structure obtenue à l'étape b),
d) la formation d'un siliciure de métal (110) sur lesdites zones,
e) un retrait du métal n'ayant pas réagi et de l'alliage ternaire métal-silicium-germanium éventuellement formé,
f) un retrait de la couche de l'alliage de silicium et de germanium (10) afin de découvrir le composant non siliciuré.

7. Procédé de protection selon l'une quelconque des revendications 1 à 6, **caractérisé par le fait que** le matériau à protéger appartient à une ligne de polysilicium.

8. Procédé de protection selon l'une quelconque des revendications 1 à 6, **caractérisé par le fait que** le matériau à protéger appartient à l'une au moins des régions de source, de drain et de grille d'un transistor.
